# EUROPÄISCHE PATENTSCHRIFT

(11) **EP 1 299 897 B1**
(45) Veröffentlichungstag und Bekanntmachung des Hinweises auf die Patenterteilung: **09.04.2008**
(21) Anmeldenummer: 01945326.5
(22) Anmeldetag: 29.06.2001
(51) Int. Cl.: H01J 37/244

(54) **DETEKTOR FÜR VARIIERENDE DRUCKBEREICHE UND ELEKTRONENMIKROSKOP MIT EINEM ENTSPRECHENDEN DETEKTOR**
DETECTOR FOR VARIABLE PRESSURE AREAS AND AN ELECTRON MICROSCOPE COMPRISING A CORRESPONDING DETECTOR
DETECTEUR DESTINE A DES PLAGES DE PRESSION VARIABLES ET MICROSCOPE ELECTRONIQUE DOTE D'UN DETECTEUR CORRESPONDANT

(30) Priorität: 07.07.2000 DE 10032599; 31.05.2001 DE 10126698
(43) Veröffentlichungstag der Anmeldung: 09.04.2003
(73) Patentinhaber: Carl Zeiss NTS GmbH, 73446 Oberkochen (DE)
(72) Erfinder: GNAUCK, Peter, 72764 Reutlingen (DE); DREXEL, Volker, 89551 Königsbronn (DE); BATE, David, Cambridge CB 19TN (GB); ESSERS, Erik, 73430 Aalen (DE)
(74) Vertreter: Gnatzig, Klaus
(86) Internationale Anmeldenummer: PCT/EP2001/007431
(87) Internationale Veröffentlichungsnummer: WO 2002/005309

(56) Entgegenhaltungen:
- WO-A-01/41180
- WO-A-98/22971
- US-A- 4 992 662
- PATENT ABSTRACTS OF JAPAN vol. 1999, no. 09, 30. Juli 1999 (1999-07-30) & JP 11 096956 A (HITACHI LTD;HITACHI SCI SYST LTD), 9. April 1999 (1999-04-09) in der Anmeldung erwähnt

## Beschreibung

Die Erfindung betrifft einen Detektor für die in einem Teilchenstrahlgerät durch Wechselwirkung eines Primärstrahles mit einer zu untersuchenden Probe entstehenden Wechselwirkungsprodukte, insbesondere Rückstreuelektronen und Sekundärelektronen.

Üblicherweise werden für den Nachweis von Sekundärelektronen oder Rückstreuelektronen in Rasterelektronenmikroskopen sogenannte Everhard-Thornley Detektoren (ETD) verwendet, bei denen die auf der Probenoberfläche ausgelösten Sekundärelektronen oder Rückstreuelektronen durch ein Absauggitter von der Probe zu dem Detektor hin weggesaugt werden und anschließend auf einen auf einem Hochspannungspotential von etwa 10 kV liegenden Szintillator beschleunigt werden. Beim Auftreffen der hochkinetischen Elektronen auf dem Szintillator werden Photonen erzeugt, die über einen transparenten Lichtleiter einem Lichtdetektor, beispielsweise einem Photomultiplier zugeführt werden.

Derartige Everhard-Thornley Detektoren sind bei variierenden Gasdrücken im Bereich des Detektors, insbesondere wenn der Umgebungsdruck des Detektors oberhalb 10⁻³ hPa beträgt, nicht einsetzbar, da durch die erhöhte Leitfähigkeit des Restgases die an den Szintillator angelegte Hochspannung zu Überschlägen führt.

Bei Drücken oberhalb 10⁻³ hPa in der Präparatkammer wird zur indirekten Detektion der vom Primärstrahl ausgelösten Sekundärelektronen üblicherweise ein Absaugpotential von bis zu 400 V an eine Elektrode angelegt, um die ausgelösten Sekundärelektronen von der Probe weg zu beschleunigen. Dabei entsteht durch Stöße der Sekundärelektronen eine Gaskaskade. In dieser Gaskaskade entstehen weitere, tertiäre Elektronen sowie zusätzlich durch Szintillationseffekte Photonen. Die Signalerfassung erfolgt dann entweder über die Messung des Elektronenstroms oder durch Detektion der Photonen. Entsprechende Detektionsprinzipien sind beispielsweise in der US 4,785,182 und der WO 98/22971 beschrieben.

Geräte, die zum Betrieb unter variierenden Druckverhältnissen in der Präparatkammer ausgelegt sind, mit denen also die elektronenmikroskopische Untersuchung von Proben sowohl unter Hochvakuumbedingung erfolgen kann als auch unter sogenannten Umgebungsbedingungen, bei denen der Druck in der Präparatkammer über 10⁻³ hPa beträgt, müssen für die verschiedenen Betriebsmodi verschiedene Detektoren aufweisen.

Aus der JP 11096956 A ist ein Detektor für Rasterelektronenmikroskope bekannt, bei dem der selbe Lichtdetektor sowohl zum Nachweis von Cathodolumineszenz als zum Nachweis von Rückstreuelektronen dient. Dazu weist der Detektor einen an einen Lichtleiter angeschlossenen Szintillator auf, dessen Ende konkav geformt und verspiegelt ist. Die Rückstreuelektronen dringen in die Spiegelschicht ein und erzeugen im Szintillator Lichtblitze, die vom Lichtdetektor nachgewiesen werden; die Cathodolumineszenz hingegen wird von der spiegelnden Oberfäche des Szintillators auf eine andere Lichteintrittsfläche des Lichtleiteres fokussiert.

Nachteilig bei diesem Detektor ist jedoch, daß der Szintillator zwischen der Probe und der Objektivlinse des Rasterelelektronenmikroskopes angeordnet sein muß, so daß ein entsprechend großer Arbeitsabstand zwischen der Objektivlinse und der Probe erforderlich ist; wegen der dadurch resultierenden Streuung der Elektronen an Gasmolekülen ist dieser Detektor für Anwendungen mit höheren Drücken in der Probenkammer ungeeignet. Außerdem stört der Szintillator bei einen Kippung der Probe.

In der DE 40 09 692 A1 ist ein Everhard-Thornley Detektor beschrieben, dessen Oberfläche mit einem Metallgitter versehen ist. Das Metallgitter dient u.a. zur Verhinderung von Oberflächenaufladungen des nichtleitenden Szintillators. Ein Einsatz des Detektors bei unterschiedlichen Drücken in der Probenkammer ist dort nicht angesprochen.

Ziel der vorliegenden Erfindung ist es deshalb, einen Detektor zu schaffen, der sowohl unter Hochvakuumbedingungen als auch bei hohen Drücken in der Präparatkammer eines Elektronenmikroskops einsetzbar ist. Es ist ein weiteres Ziel der Erfindung, ein Verfahren zum Nachweis von Wechselwirkungsprodukten in einem Teilchenstrahlgerät anzugeben, bei dem bei unterschiedlichen Drücken in der Präparatkammer Wechselwirkungsprodukte des Teilchenstrahl mit einer Probe mit demselben Detektor nachgewiesen werden können.

Dieses Ziel wird durch einen Detektor mit den Merkmalen des Anspruches 1 und ein Verfahren mit den Merkmalen des Anspruchs 16 gelöst. Vorteilhafte Ausgestaltungen der Erfindung ergeben sich aus den Merkmalen der abhängigen Ansprüche.

Ein erfindungsgemäßer Detektor ist sowohl für den Nachweis von Elektronen als auch für den Nachweis von Licht ausgelegt. Der Nachweis der Elektronen erfolgt dabei indirekt über in einem Szintillator erzeugte Photonen, die nachfolgend mit einem Lichtdetektor detektiert werden. Der Szintillator ist mit einem Hochspannungspotential beaufschlagbar und ist für Licht in einem Spektralbereich, vorzugsweise im sichtbaren Spektralbereich, durchlässig ausgebildet. Für die Beaufschlagung des Szintillators mit einem Hochspannungspotential kann der Szintillator gitter- oder streifenweise mit einer elektrisch leitenden Beschichtung versehen sein. Alternativ kann auf dem Szintillator eine elektrisch leitende, für sichtbares Licht durchlässige Beschichtung vorgesehen sein.

Weiterhin sollte der Detektor ein Kollektorgitter aufweisen, das auf der dem Lichtdetektor abgewandten Seite des Szintillators angeordnet ist und ebenfalls mit einem Potential beaufschlagbar ist. Der Szintillator und das Kollektorgitter sollten dabei unabhängig voneinander mit regelbaren Spannungen beaufschlagbar sein.

Die Funktionsweise eines entsprechenden Detektors unter Hochvakuumbedingungen ist analog zu der Funktionsweise eines Everhard-Thornley Detektors. Der Szintillator wird dazu unter Hochvakuumbedingungen mit einem Potential von etwa 10 kV (zwischen 5 kV und 15 kV) beaufschlagt, so daß die auf den Szintillator auftreffenden hochenergetischen Elektronen Photonen erzeugen, die nachfolgend mit dem Lichtdetektor nachgewiesen werden. Bei Drücken in der Präparatkammer über 10⁻³ hPa wird entweder das Kollektorgitter oder der Szintillator oder beide auf ein niedriges Potential zwischen 50 V und 1000 V, vorzugsweise zwischen 100 und 500 V, gelegt, so daß die von den Primärelektronen aus der Probe ausgelösten Sekundärelektronen oder Rückstreuelektronen eine Gaskaskade mit Szintillationseffekten auf dem Weg von der Probe zum Szintillator bzw. Kollektorgitter erzeugen. Durch die transparente Szintillatorbeschichtung werden dann die in der Gaskaskade erzeugten Photonen mit dem Lichtdetektor detektiert. Der Wert der an dem Szintillator oder an das Kollektorgitter angelegten Spannung ist dabei vom gewählten Druck in der Präparatkammer und Geometriefaktoren abhängig.

Durch Variation der Spannung am Kollektorgitter ist es zusätzlich möglich, zwischen Sekundärelektronen und an der Probe zurückgestreuten Elektronen zu unterscheiden. Liegt sowohl das Kollektorgitter als auch der Szintillator auf demselben Potential wie die Probe, so entsteht keine Gaskaskade und das mit dem Lichtdetektor durch den transparenten Szintillator hindurch detektierte Lichtsignal ist ein Signal, das ausschließlich von an der Probe zurückgestreuten Elektronen her rührt.

Bei einem weiterhin vorteilhaften Ausführungsbeispiel weist der Detektor einen Lichtleiter auf. Der Lichtleiter kann dabei selbst aus einem Szintillatormaterial bestehen. Ein solcher Lichtleiter dient dabei zu einer effizienten Leitung der im Szintillator erzeugten Photonen zum Lichtdetektor.

Bei einem weiterhin vorteilhaften Ausführungsbeispiel ist die Kollektorelektrode als Nadelelektrode oder als dünne Drähte ausgebildet. Außerdem können weitere Elektroden vorgesehen sein, die den Szintillator und die Kollektorelektrode topfförmig umgeben und dadurch eine Detektionskammer in ihrem Inneren bilden, die mit der Probenkammer nur über eine kleine Öffnung kommuniziert.

Bei hohen Drücken in der Umgebung des Detektors kann zusätzlich zum Lichtsignal auch der Elektronenstrom auf dem Absauggitter und/oder auf dem elektrisch leitend beschichteten Szintillator nachgewiesen werden.

Nachfolgend werden Einzelheiten der Erfindung anhand des in den Figuren dargestellten Ausführungsbeispiels näher erläutert.

Im einzelnen zeigen:
- Figur 1:: Eine Prinzipskizze eines erfindungsgemäßen Detektors im Schnitt beim Betrieb im Hochvakuum;
- Figur 2:: den Detektor aus Figur 1 beim Betrieb in einem Druckbereich oberhalb 10⁻³ hPa;
- Figur 3:: eine weitere Ausführungsform des erfindungsgemäßen Detektors beim Betrieb in einem Druckbereich oberhalb 10⁻³ hPa; und
- Figur 4:: ein drittes Ausführungsbeispiel für einen erfindungsgemäßen Detektor.

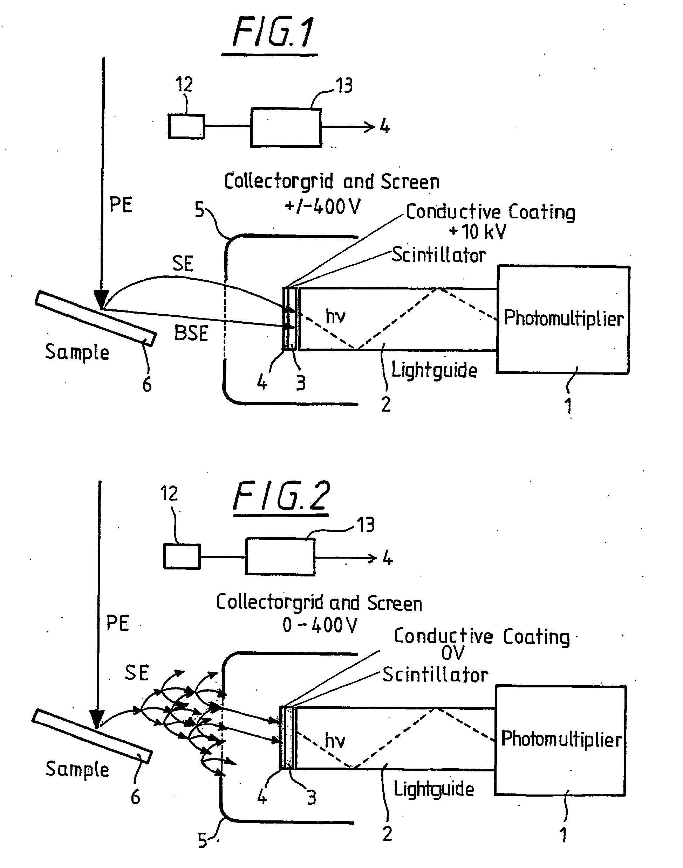

Der Detektor in Figur 1 enthält einen Lichtdetektor (1), beispielsweise in Form eines Photomultipliers oder einer Avalanche Photodiode, dem Lichtdetektor (1) vorgeschaltet einen Lichtleiter (2) und an der vom Lichtdetektor (1) abgewandten Stirnfläche des Lichtleiters (2) einen Szintillator (3).

An dieser Stelle sei darauf hingewiesen, daß der Lichtleiter (2) nicht zwingend notwendig ist, sondern der Szintillator auch unmittelbar vor dem Lichtdetektor (1) angebracht sein kann. In diesem Fall müßte allerdings der Lichtdetektor (1) innerhalb der Präparatkammer des Elektronenmikroskopes angeordnet werden, während mit Lichtleiter (2) der Lichtdetektor (1) außerhalb der Präparatkammer angeordnet sein kann, da das innerhalb der Präparatkammer im Szintillator erzeugte Licht durch den Leiterleiter (2) zum Lichtdetektor (1) geleitet wird.

Weiterhin sei an dieser Stelle darauf hingewiesen, daß der Lichtleiter (2) selbst auch als Szintillator ausgebildet sein kann, so daß dann auf eine separate Szintillatorschicht (3) verzichtet werden kann.

Der Szintillator (3) besteht aus einem für sichtbares Licht transparenten Material, beispielsweise einem üblichen Plastikszintillator. Auf der vom Lichtdetektor (1) abgewandten Seite ist der Szintillator (3) mit einer elektrisch leitenden, für sichtbares Licht durchlässigen Beschichtung (4) versehen. Die elektrisch leitende Beschichtung (4) kann dazu als übliche Metallschicht ausgebildet sein, die gitter- oder streifenförmig oder als dünner Metallfilm, beispielsweise aus Titan oder Gold, mit einer Dicke zwischen 5 nm und 30 nm, vorzugsweise mit einer Dicke zwischen 3 und 30 nm, auf die Stirnfläche des Lichtleiters (2) aufgebracht ist. Alternativ kommt auch eine durchgängige Beschichtung mit einem elektrisch leitenden, lichtdurchlässigen Material, beispielsweise ITO, in Frage.

Die Einheit aus Lichtleiter (2), Szintillator (3) und transparente, elektrisch leitende Beschichtung (4) ist in einem Abstand von einem Kollektorgitter (5) umgeben.

In der Probenkammer ist ein Drucksensor (12) angeordnet, der den Druck in der Probenkammer mißt und die Potentialbeaufschlagung des Szintillators (3) und /oder des Kollektorgitters (5) in Abhängigkeit des Kammerdruckes über eine Regelung (13) regelt.

Unter Hochvakuumbedingungen, also bei Drücken in der Präparatkammer unter einem Umschaltdruck, der zwischen 10⁻³ hPa und 10⁻² hPa liegt, ist der Szintillator (3) bzw. die elektrisch leitende, lichtdurchlässige Beschichtung (4) des Szintillators (3) mit einem Potential von 5 kV bis 15 kV beaufschlagt. Das Kollektorgitter (5) ist, je nach dem ob an der Probe (6) zurückgestreute Elektronen (BSE) oder an der Probe (6) erzeugte Sekundärelektronen (SE) detektiert werden sollen, mit einem bzgl. der Polarität umkehrbaren, Potential von etwa 400 V beaufschlagt. Ist der Nachweis nur von Rückstreuelektronen (BSE) gewünscht, so wird das Kollektorgitter mit einem gegenüber der Probe (6) negativen Potential beaufschlagt. Durch dieses negative Potential werden die Sekundärelektronen, die nur mit einer geringen Energie von einigen Elektronenvolt aus der Probe (6) austreten, durch das Kollektorgitter vom Szintillator (3) abgehalten. Auf den Szintillator (3) treffen demzufolge nur diejenigen Elektronen auf, die aufgrund ihrer höheren kinetischen Energie das Gegenpotential des Kollektorgitters überwinden können. Dieses sind die an der Probe (6) zurückgestreuten Elektronen. Diese zurückgestreuten Elektronen werden zwischen dem Kollektorgitter (5) und dem Szintillator (3) auf das Szintillatorpotential beschleunigt und erzeugen aufgrund ihrer hohen Energie im Szintillator (3) Photonen, die vom Lichtleiter (2) zum Lichtdetektor (1) geleitet und dort nachgewiesen werden.

Ist der Nachweis von aus der Probe (6) durch die Primärelektronen PE ausgelösten Sekundärelektronen gewünscht, wird an das Kollektorgitter (5) ein gegenüber dem Potential der Probe (6) positives Potential angelegt. Durch dieses positive Potential des Kollektorgitters werden die aus der Probe (6) ausgelösten Sekundärelektronen abgesaugt und nachfolgend zwischen dem Kollektorgitter (5) und dem Szintillator (3) auf das Szintillatorpotential beschleunigt. In diesem Fall lösen auch die beschleunigten Sekundärelektronen aufgrund ihrer hohen kinetischen Energie im Szintillator (3) Photonen aus, die nachfolgend mit dem Lichtdetektor (1) nachgewiesen werden. Zwar treffen bei gegenüber dem Probenpotential positivem Potential des Kollektorgitters auch an der Probe (6) zurückgestreute Elektronen auf den Szintillator (3) auf, jedoch wird von sämtlichen an der Probe (6) zurückgestreuten Elektronen nur ein sehr kleiner Raumwinkelbereich erfaßt, während die Sekundärelektronen wegen ihrer geringeren kinetischen Energie beim Austritt aus der Probe (6) nahezu unabhängig von ihrer Austrittsrichtung erfaßt werden. Aus diesem Grund ist das mit dem Lichtdetektor (1) detektierte Signal bei gegenüber dem Probenpotential positiven Potential des Kollektorgitters primär durch die aus der Probe (6) austretenden Sekundärelektronen bestimmt, während die an der Probe (6) zurückgestreuten Elektronen nur einen vergleichsweise geringen Signaluntergrund verursachen.

Beim Betrieb des Detektors unter hohen Kammerdrücken (Figur 2) liegt der Szintillator (3) auf dem Potential der Probe (6). Das Kollektorgitter wird gleichzeitig mit einem variierbaren Potential zwischen 0 und + 400 V gegenüber dem Potential der Probe (6) beaufschlagt. Falls nur der Nachweis der an der Probe (6) zurückgestreuten Elektronen gewünscht ist, wird das Kollektorgitter auf das Potential der Probe (6) gelegt. Die an der Probe (6) zurückgestreuten und aufgrund ihres Rückstreuwinkels auf den Szintillator (3) auftreffenden Rückstreuelektronen erzeugen im Szintillator (3) wiederum, wie beim Hochvakuumbetrieb, aufgrund ihrer relativ hohen kinetischen Energie Photonen, die nachfolgend mit dem Lichtdetektor (1) nachgewiesen werden. Ist hingegen der Nachweis von Sekundärelektronen gewünscht, wird das Kollektorgitter mit einem gegenüber dem Probenpotential (6) positiven Potential beaufschlagt. Die aus der Probe (6) austretenden Sekundärelektronen werden dann auf das Kollektorgitter hinzu beschleunigt und erzeugen durch Stöße mit den Gasatomen auf diesem Weg die bekannte Gaskaskade und die gleichzeitig mit der Gaskaskade auftretenden Photonen. Diese Photonen passieren die für sichtbares Licht transparente elektrisch leitende Beschichtung (4), den ebenfalls für sichtbares Licht durchlässigen Szintillator (3) und werden nachfolgend vom Lichtleiter (2) zum Lichtdetektor (1) geleitet. Zusätzlich oder alternativ zur Erfassung der erzeugten Photonen kann in diesem Betriebsmodus auch der durch die Gaskaskade erzeugte, mit dem Kollektorgitter bzw. mit der elektrisch leitenden Beschichtung (4) erfaßte Elektronenstrom zur Signalgewinnung herangezogen werden.

Die Umschaltung der Potentialbeaufschlagung des Szintillators erfolgt automatisch durch die Regelung (13) in Abhängigkeit des vom Drucksensor (12) ermittelten Druckes in der Probenkammer. Überschreitet der Kammerdruck den voreingestellten Umschaltdruck, wird automatisch das Potential des Szintillators abgeschaltet oder reduziert das Potential des Szintillators so, daß Spannungsüberschläge ausgeschlossen sind; unterschreitet der Kammerdruck den Umschaltdruck wird das voreingestellte Szintillatorpotential an den Szintillator (3) wieder angelegt.

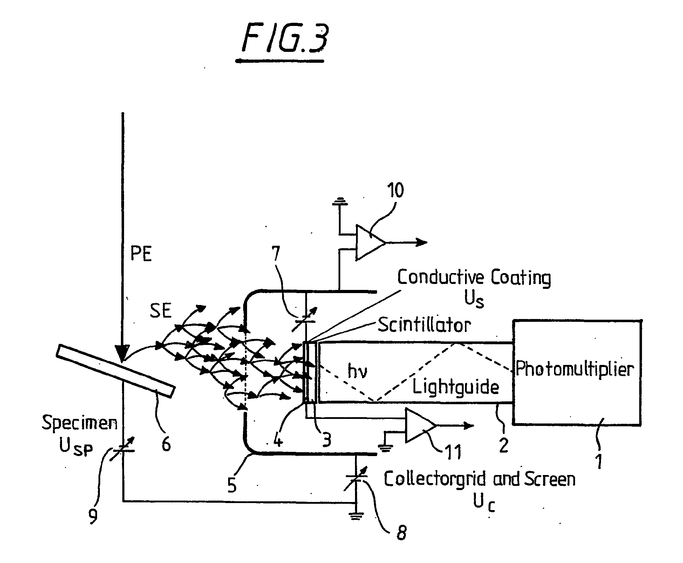

Der Detektor in Figur 3 hat im Prinzip denselben Aufbau wie der Detektor in Figur 1. Deshalb sind in der Figur 3 diejenigen Komponenten, die denen in Figur 1 entsprechen, mit den selben Bezugszeichen versehen. Hinsichtlich einer detaillierten Beschreibung dieser Komponenten und des Betriebes dieses Detektors im Hochvakuum wird deshalb auf die vorstehende Beschreibung zur Figur 1 verwiesen.

Beim Ausführungsbeispiel nach Figur 3 ist zusätzlich zu der Spannungsquelle (8) für die Potentialbeaufschlagung des Kollektorgitters (5) und eine Spannungsquelle (9) zur Einstellung eines variablen Probenpotentials eine weitere Spannungsquelle (7) vorgesehen, durch die die elektrisch leitende Beschichtung (4) des Szintillators (3) auf ein gegenüber dem Kollektorgitter (5) positives Potential US gelegt werden kann. Das Potential der elektrisch leitenden Beschichtung (4) gegenüber dem Kollektorgitter (5) ist dabei variierbar. Durch Anlegen dieser zusätzlichen Spannung US zwischen der elektrisch leitenden Beschichtung (4) des Szintillators (3) und dem Kollektorgitter (5) wird zwischen dem Kollektorgitter (5) und dem Szintillator (3) eine weitere Gaskaskade ausgebildet. Zur Signalgewinnung kann wiederum sowohl das mit dem Lichtdetektor (1) detektierte Lichtsignal als auch der auf das Kollektorgitter (5) und/oder die elektrisch leitende Beschichtung (4) einfallende Elektronenstrom detektiert werden, wozu an das Kollektorgitter (5) ein entsprechender Stromverstärker (10) und an die elektrisch leitende Beschichtung (4) ein zweiter Stromverstärker (11) angeschlossen ist. Durch Variation der Spannung des Kollektorgitters (5) gegenüber dem Probenpotential einerseits und der Spannung zwischen der elekrisch leitenden Beschichtung (4) und dem Kollektorgitter (5) kann gegenüber dem Ausführungsbeispiel nach Figur 1 und 2 mit erhöhter Genauigkeit zwischen den von Sekundärelektronen erzeugten Signalen und dem von Rückstreuelektronen erzeugten Signal unterschieden werden.

Insbesondere ist es bei diesem Ausführungsbeispiel auch möglich, das Kollektorgitter (5) nur so schwach mit gegenüber dem Probenpotential positivem Potential und die leitende Beschichtung (4) des Szintillators so stark mit gegenüber dem Kollektorgitter (5) positivem Potential zu beaufschlagen, daß die aus der Probe austretenden Sekundärelektronen zwar effizient durch das Potential des Kollektorgitters abgesaugt werden, jedoch zwischen der Probe und dem Kollektorgitter noch keine Gaskaskade mit der damit verbundenen Sekundärelektronenvervielfachung entsteht, sondern die Gaskaskade erst zwischen dem Kollektorgitter (5) und dem Szintillator entsteht. Da die Gaskaskade dadurch in der Nähe des Szintillators lokalisiert ist und die bei der Ausbildung der Gaskaskade entstehenden Photonen in diesem lokalisierten Raum entstehen, erfolgt der Nachweis der Photonen mit einem höheren Wirkungsgrad. Weiterhin ist es durch eine separate Regelung des Druckes zwischen dem Kollektorgitter und dem Szintillator, z.B. durch Ausbildung des Kollektorgitters als Topf mit einer relativ kleinen, der Probe zugewandten Öffnung, die eine "Druckstufenblende" bildet und durch einen gezielten Gaseinlaß in das Innere des Topfes, möglich, zwischen dem Kollektorgitter und dem Szintillator einen vom Kammerdruck abweichenden und bis zu einem gewissen Grad unabhängigen Druck einzustellen. Dadurch resultiert dann eine vom Druck in der Kammer bis zu diesem Grad unabhängige Ausbildung der Gaskaskade und entsprechende unabhängige Verstärkung der Sekundärelektronen und Photonen. Auch läßt sich durch diese Maßnahmen eine Vervielfachung der Sekundärelektronen auch dann erreichen, wenn der Druck in der Präparatkammer selbst für die Ausbildung einer Gaskaskade zu gering ist.

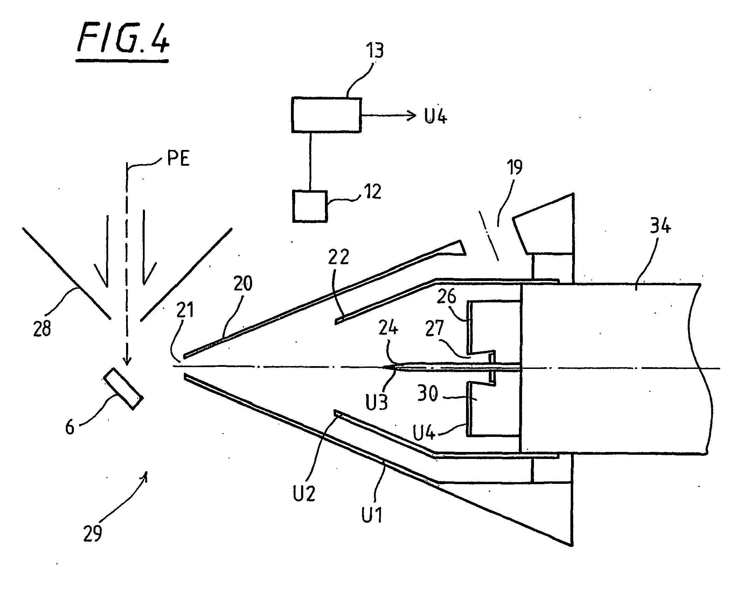

Das Ausführungsbeispiel in Figur 4 hat einen ähnlichen Aufbau wie das Ausführungsbeispiel in Figur 3, ist jedoch in Richtung auf die Probe, also auf der vom Lichtdetektor abgewandten Seite, konisch spitz zulaufend ausgebildet. Es hat einen Lichtleiter (34), an den probenseitig ein Szintillator (30) angesetzt ist. Der Szintillator (30) ist probenseitig mit einer für Licht durchlässigen Elektrode (26) versehen, die entweder wiederum als dünne Metallschicht oder gitterförmig ausgebildet ist.

In einer zentralen Vertiefung (27) in der probenseitigen Frontfläche des Szintillators (30) ist eine sich in Richtung der Probe erstreckende, probenseitig spitz zulaufende Nadelelektrode (24) aufgenommen. Die Vertiefung (27) dient dabei ausschließlich zur elektrischen Isolierung der Nadelelektrode (24) gegenüber der Szintillatorelektrode (26).

Außen am Lichtleiter (34) ist eine mittlere Elektrode (22) aufgenommen, die die Nadelelektrode (24) topfförmig umgibt und probenseitig konisch zulaufend ausgebildet ist, so daß sich eine probenseitige Öffnung (23) mit einem Öffnungsdurchmesser zwischen 0, 5 und 5 mm zum Eintritt von Elektronen ergibt. Die Mittlere Elektrode (22) ist innenseitig verspiegelt.

Bei einer speziellen Ausgestaltung des Ausführungsbeispiels ist die innere Elektrode (22) noch von einer weiteren äußeren Elektrode (20), die ebenfalls in Richtung auf die Probe spitz zulaufend ausgebildet ist und probenseitig ebenfalls eine Eintrittsöffnung (21) bildet, umgeben. Zwischen dieser äußeren Elektrode (20) und der mittleren Elektrode (22) kann über einen Gaseinlaß (19) das Gas und dessen Druck in diesem Zwichenraum teilweise unabhängig von Gas und Druck in der Probenkammer eingestellt werden. Wenn in der Detektionskammer, also dem Zwischenraum zwischen der mittleren Elektrode (22) und der äußeren Elektrode (20) ein etwas höherer Druck als in der Probenkammer herrscht, hat dieses den Vorteil, daß das aus der Probenkammer in die Detektionskammer hinein diffundierende Gas ständig wieder aus der Detektionskammer herausgespült wird.

Die äußere Elektrode (20) dient einerseits zum Abschirmen des Hochspannungspotentials, das beim Hoch-Vakuumbetrieb an der Szintillatorelektrode (26) anliegt, gegenüber dem Primärelektronenstrahl (PE). Weiterhin dient die äußere Elektrode (20) zum Anziehen von Sekundärelektronen von der Probe zur Öffnung (21). Durch die spitz zulaufende Bauform der äußeren Elektrode (20) wird der unerwünschte Signalbeitrag durch Sekundärelektronen, die von Rückstreuelektronen im Gas der Probenkammer erzeugt werden, möglichst gering gehalten, weil nur solche Sekundärelektronen durch die Öffnung gelangen, die sich in nicht zu großer Entfernung von der Öffnung befinden, d.h. das schwache Fernfeld der spitz zulaufenden äußeren Elektrode sorgt dafür, daß nur aus einem eng begrenzten Volumen die Sekundärelektronen durch die Öffnung (21) gelangen.

Das Potential U1 der äußeren Elektrode (20) sollte in einem Bereich 0 - 500 V positiv gegenüber der Probe einstellbar sein. Ein stark positives Potential über 200 V hat den Vorteil, daß dadurch in der Probenkammer eine Gaskaskade erzeugt wird, die auf die Öffnung (21) der äußeren Elektrode zuläuft. Dadurch wird die Detektionseffizienz gesteigert, indem mehr Elektronen in die Detektionskammer gelangen. Außerdem haben die Elektronen, die in die Detektionskammer eintreten - besonders bei nicht zu hohem Gasdruck - eine höhere mittlere kinetische Energie, so daß sie sich von der Querkomponente des elektrischen Feldes - quer zur Rotationsachse des Detektors - die die Elektronen von Innen an die äußere Elektrode drückt, weniger beeinflußen lassen. Bei schwachem positiven Potential unter 50 V positiv gegenüber der Probe kann ein günstiger Verlauf des elektrischen Feldes eingestellt werden, bei dem die Sekundärelektronen beim Durchqueren oder nach dem Durchqueren der Öffnung (21) weniger oder gar nicht gegen die äußere Elektrode (20) gedrückt werden.

Zur Verringerung des indirekten Signalanteils, den die Rückstreuelektronen über diejenigen Sekundärelektronen liefern, die durch Kollision der Rückstreuelektronen mit dem Polschuh (28) der Objektivlinse erzeugen, ist es hilfreich, wenn das Potential der Probe leicht, d.h. ca. 50 V, negativ gegenüber dem Potential des Polschuhs ist. Durch eine Netzelektrode auf Probenpotential (oder auf einem anderen Potential, das näher am Potential der Probe als am Potential des Polschuhs liegt) zwischen der Probe und dem Polschuh kann erreicht werden, daß der Raum unmittelbar oberhalb des Polschuhs nahezu feldfrei ist und das Absaugen der Sekundärelektronen durch die weitere Elektrode (20) nicht beeinträchtigt wird.

Die mittlere Elektrode (22) dient ebenfalls dazu, den Anteil der Sekundärelektronen, die gegen die äußere Elektroden gedrückt werden, gering zu kalten, indem die Sekundärelektronen nach Eintritt in die Detektionskammer weiter in Richtung auf den Szintillator gelenkt werden. Dazu ist das Potential der mittleren Elektrode 30 V bis 500 V positiv gegenüber dem Potential der äußeren Elektrode (20).

Soweit die äußere Elektrode (20) nicht vorhanden ist, erfüllt natürlich die mittlere Elektrode (22) zum Teil deren Aufgaben.

Durch die innere Verspiegelung der mittleren Elektrode (22) wird die Detektionseffizienz für Photonen erhöht, indem diejenigen Photonen, die auf die Innenfläche der mittleren Elektode auftreffen, zum Lichtleiterende reflektiert werden. Eine ähnliche Wirkung hat auch eine schwach Licht absorbierende, streuende Innenbeschichtung der mittleren Elektrode, allerdings mit geringerer Effizienz, da mit einer Verspiegelung die Photonen zielgerichtet zum Lichtleiter gelenkt werden können.

Wenn an die Nadelelektrode (24) eine Potentialdifferenz zum Umgebungspotential angelegt wird, tritt an der Nadelspitze eine hohe Feldstärke auf. Dadurch wird erreicht, daß bei hohem Gasdruck der Großteil der Potentialdifferenz auf einer kurzen Strecke liegt, so daß das Produkt aus Gasdruck und Strecke auf den Optimalwert für eine starke Gaskaskade eingestellt werden kann und die Gaskaskade vornehmlich in der Detektionskammer entsteht. Im Betrieb mit hohem Druck in der Probenkammer dient die Nadelelektrode als Kollektorelektrode. Mit einem an die Nadelelektrode angeschlossenen Stromverstärker kann auch der Sekundärelektronenstrom detektiert werden, so daß dann auf den Lichtleiter und den Lichtdetektor verzichtet werden kann, wenn der Detektor nur bei hohen Kammerdrücken eingesetzt werden soll.

Das im Prinzip selbe Ergebnis wie mit der Nadelelektrode (24) kann auch erreicht werden, wenn statt dessen eine Elektrode aus mehreren dünnen Drähten (Drahtstärke unter 0,3 mm), die parallel zur Szintillatorelektrode (26) gespannt sind oder eine Netzelektrode nahe vor der Szintillatorelektrode (26), im Abstand von unter 20 mm, bevorzugt im Abstand unter 10 mm angeordnet ist. Im letzteren Fall bestimmt der Abstand zwischen der Netzelektrode und der Szintillatorelektrode (26) die hohe Feldstärke.

Beim Betrieb mit hohem Druck (über 500 Pa) in der Probenkammer sollte das Potential U3 der Nadelelektrode (24) mindestens 200 V positiv gegenüber dem Potential der mittleren Elektrode sein. Bei mittleren Drücken zwischen 1 Pa und 500 Pa sollte das Potential der Nadelelektrode (24) zwischen dem Potential der mittleren Elektrode (22) und dem Potential der Szintillatorelektrode (26) liegen; dadurch wird erreicht, daß die Gaskaskade etwas auseinander gespreizt wird. Im Hochvakuumbetrieb sollte das Potential der Nadelelektrode (24) ebenfalls zwischen dem Potential der mittleren Elektrode (22) und dem Potential der Szintillatorelektrode (26) liegen, kann jedoch auch mit dem Potential einer der beiden Elektroden (22, 26) übereinstimmen.

Das Potential U4 der Szintillatorelektrode (26) liegt wie bei den anderen Ausführungsformen bei Betrieb im Hochvakuum auf Hochspannungspotential. Bei mittleren Kammerdrücken sollte die Gaskaskade an der Nadelelektrode (24) enden. Bei hohem Druck in der Probenkammer liegt das Potential der Szintillatorelektrode (26) zwischen dem Potential der Nadelelektrode (24) und dem der mittleren Elektrode (22). Hierdurch wird ein Feldverlauf erreicht, der einerseits als Absaugfeld in der Öffnung der mittleren Elektrode (22) hilfreich ist. Andererseits führt der Feldverlauf die Sekundärelektronen in die Nähe der Nadelelektrode, wo sie vom positiven Potential der Nadelelektrode angezogen werden.

Wie bei den anderen Ausführungsbeispielen dient der Szintillator (30) im Hoch-Vakuumbetrieb zur Erzeugung von Photonen, die anschließend von einem Photomultiplier verstärkt und detektiert werden.

Die Gaszufuhr gibt im Hochvakuumbetrieb die Möglichkeit, wie bei Betrieb mit hohem Kammerdruck eine Gaskaskade in der Detektionskammer zu erzeugen. Außerdem kann das Gas der Detektionskammer unabhängig vom Gas in der Probenkammer gewählt werden und dadurch für eine starke Gaskaskade ein Gas mit einem höheren Verstärkungsfaktor für die Sekundärelektronenvervielfachung gewählt werden.

## Patentansprüche

1. Detektor für Teilchenstrahlgeräte, der sowohl bei Hochvakuum als auch bei Drücken über 10⁻³ hPa in der Präparatkammer eines Teilchenstrahlgerätes einsetzbar ist, wobei der Detektor einen mit einem Hochspannungspotential beaufschlagbaren Szintillator (3) und einen Lichtdetektor (1) aufweist, **dadurch gekennzeichnet, dass** der Szintillator (3) eine gitterartig oder streifenweise ausgebildete elektrisch leitende Beschichtung (4) oder eine für Licht durchlässige, elektrisch leitende Beschichtung (4) aufweist und dadurch sowohl für die Detektion von Elektronen als auch für die Detektion von Licht ausgelegt ist.

2. Detektor nach Anspruch 1, wobei der Detektor einen Lichtleiter (2) zwischen Szintillator (3) und Lichtdetektor (1) aufweist.

3. Detektor nach Anspruch 2, wobei der Lichtleiter (2) aus Szintillatormaterial besteht.

4. Detektor nach einem der Ansprüche 1 bis 3, wobei der Detektor eine dem Szintillator (3) vorgeschaltete Kollektorelektrode (5) aufweist.

5. Detektor nach Anspruch 4, wobei die elektrisch leitende Beschichtung (4) des Szintillators (3) und die Kollektorelektrode (5) unabhängig voneinander mit regelbaren Potentialen beaufschlagbar sind.

6. Detektor nach Anspruch 4 oder 5, wobei die Kollektorelektrode (5) mit einem variierbaren, gegenüber dem Probenpotential positiven Potential beaufschlagbar ist.

7. Detektor nach einem der Ansprüche 4 bis 6, wobei an die Kollektorelektrode (5) und /oder an die leitende Beschichtung (4) des Szintillators (3) Stromverstärker angeschlossen sind.

8. Detektor nach einem der Ansprüche 4-7, weiter enthaltend Spannungsquellen (7, 8), die im Betrieb eine Potentialdifferenz zwischen der leitenden Beschichtung (4) des Szintillators (3) und der Kollektorelektrode (5) derart erzeugen, so dass im Betrieb eine Gaskaskade zwischen der Kollektorelektrode (5) und der leitenden Beschichtung (4) entsteht.

9. Detektor nach einem der Ansprüche 1 - 8, wobei der Detektor eine Nadelelektrode (24) oder eine Elektrode aus dünnen Drähten probenseitig des Szintillators (3) aufweist.

10. Detektor nach einem der Ansprüche 1 - 9, wobei der Detektor eine den Szintillator (3) topfförming umgebende Elektrode (20, 22) aufweist, die auf der dem Szintillator (3) abgewandten Seite konisch spitz zuläuft und an ihrem auf der dem Szintillator (3) abgewandten Seite eine Öffnung (21, 23) aufweist.

11. Teilchenstrahlgerät, insbesondere Rasterelektronenmikroskop, mit einer Präparatkammer (29), wobei das Teilchenstrahlgerät mit variablem Druck in der Präparatkammer (29) betrieben werden kann, mit einem elektronenoptischen System zur Erzeugung eines fokussierten Elektronenstrahls (PE) und mit einem Detektor (2, 3, 4), nach einem der Ansprüche 1 bis 10.

12. Teilchenstrahlgerät nach Anspruch 11, wobei der Detektor einen Szintillator (3) aufweist und die Präparatkammer einen Drucksensor (12) aufweist und die Potentialbeaufschlagung des Szintillators (3) in Abhängigkeit des Druckes in der Präparatkammer (29) erfolgt.

13. Teilchenstrahlgerät nach Anspruch 12, weiter enthaltend eine Regelung (13) zur Umschaltung der Potentialbeaufschlagung des Szintillators in Abhängigkeit des vom Drucksensors (12) ermittelten Druckes in der Präparatkammer (29), wobei die Regelung (13) derart konfiguriert ist, dass bei Drücken unter einem Umschaltdruck zwischen 10⁻³ hPa und 10⁻² hPa in der Präparatkammer der Szintillator (3) mit einem Potential von größer 1 kV positiv gegenüber dem Potential der Probe (6) und bei Drücken über dem Umschaltdruck in der Präparatkammer der Szintillator (3) mit einem Potential von betragsmäßig kleiner 1 kV, vorzugsweise kleiner 0,5 kV, positiv gegenüber dem Potential der Probe (6) beaufschlagt ist.

14. Teilchenstrahlgerät nach Anspruch 12 oder 13, wobei der Detektor eine Kollektorelektrode (5) aufweist und das Vorzeichen des Potentials einer Kollektorelektrode (5) umkehrbar ist.

15. Teilchenstrahlgerät nach Anspruch 13 oder 14, wobei bei Drücken über dem Umschaltdruck in der Probenkammer die Kollektorelektrode (5) mit einem Potential von 0V oder +/-400 V gegenüber dem Potential der Probe (6) beaufschlagt ist.

16. Verfahren zum Nachweis von Wechselwirkungsprodukten in einem Teilchenstrahlgerät, wobei bei Drücken in der Präparatkammer unter einem Umschaltdruck das bei Auftreffen der Wechselwirkungsprodukte auf einem Szintillator entstehende Licht und bei Drücken in der Präparatkammer über dem Umschaltdruck durch Wechselwirkung der Wechselwirkungsprodukte mit Gasmolekülen entstehendes Licht mit demselben Lichtdetektor (1) detektiert und nachfolgend ausgewertet wird.

17. Verfahren nach Anspruch 16, wobei ein Detektor nach einem der Ansprüche 1 bis 10 eingesetzt wird.

## Claims

1. Detector for particle beam devices, which can be used both at high vacuum and at pressures over 10⁻³ hPa in the preparation chamber of a particle beam device, wherein the detector has a scintillator (3) to which a high-voltage potential can be applied and a photodetector (1), **characterized in that** the scintillator (3) has an electrically conducting coating, (4) which is designed in a grid-like or strip-type manner, or an electrically conducting coating (4) which is translucent to light and is therefore designed both for detecting electrons and for detecting light.

2. Detector according to Claim 1, wherein the detector has an optical waveguide (2) between scintillator (3) and photodetector (1).

3. Detector according to Claim 2, wherein the optical waveguide (2) is composed of scintillator material.

4. Detector according to one of Claims 1 to 3, wherein the detector has a collector electrode (5) connected upstream of the scintillator (3).

5. Detector according to Claim 4, wherein controllable potentials can be applied to the electrically conducting coating (4) of the scintillator (3) and to the collector electrode (5).

6. Detector according to either Claim 4 or 5, wherein a variable potential which is positive with respect to the sample potential can be applied to the collector electrode (5).

7. Detector according to one of Claims 4 to 6, wherein current amplifiers are connected to the collector electrode (5) and/or to the conducting coating (4) of the scintillator (3).

8. Detector according to one of Claims 4-7, further comprising voltage sources (7, 8) which produce a potential difference between the conducting coating (4) of the scintillator (3) and the collector electrode (5) during operation such that the result is a gas cascade between the collector electrode (5) and the conducting coating (4) during operation.

9. Detector according to one of Claims 1-8, wherein the detector has a needle electrode (24) or an electrode comprising thin wires at the sample end of the scintillator (3).

10. Detector according to one of Claims 1-9, wherein the detector has an electrode (20, 22) which surrounds the scintillator (3) in the shape of a cup, tapers conically at the side that faces away from the scintillator (3) and has an opening (21, 23) at the side that faces away from the scintillator (3).

11. Particle beam device, in particular scanning electron microscope, with a preparation chamber (29), wherein the particle beam device can be operated at variable pressure in the preparation chamber (29), with an electron-optical system for producing a focussed electron beam (PE) and with a detector (2, 3, 4) according to one of Claims 1 to 10.

12. Particle beam device according to Claim 11, wherein the detector has a scintillator (3) and the preparation chamber has a pressure sensor (12) and the potential is applied to the scintillator (3) as a function of the pressure in the preparation chamber (29).

13. Particle beam device according to Claim 12, further comprising a controller (13) for switching the application of pressure to the scintillator (3) as a function of the pressure determined by the pressure sensor (12) in the preparation chamber (29), wherein the controller (13) is configured such that, at pressures below a switching pressure between 10⁻³ hPa and 10⁻² hPa in the preparation chamber, a potential of greater than 1 kV positive with respect to the potential of the sample (6) is applied to the scintillator (3) and, at pressures above the switching pressure in the preparation chamber, a potential with a magnitude of less than 1 kV, preferably less than 0.5 kV, positive with respect to the potential of the sample (6) is applied to the scintillator (3).

14. Particle beam device according to either Claim 12 or 13, wherein the detector has a collector electrode (5) and the sign of the potential of a collector electrode (5) can be inverted.

15. Particle beam device according to either Claim 13 or 14, wherein a potential of 0 V or +/-400 V with respect to the potential of the sample (6) can be applied to the collector electrode (5) at pressures above the switching pressure in the sample chamber.

16. Method for detecting interactions products in a particle beam device, wherein the light, which is produced when the interaction products impact on a scintillator at pressures in the preparation chamber below a switching pressure, and light, which is produced by the interaction of interaction products with gas molecules at pressures in the preparation chamber above the switching pressure, can be detected, and subsequently evaluated, by the same photodetector (1) .

17. Method according to Claim 16, wherein a detector according to one of Claims 1 to 10 is used.

## Revendications

1. Détecteur pour appareils à faisceau de particules, ledit détecteur pouvant être utilisé aussi bien sous vide poussé qu'à des pressions supérieures à 10⁻³ hPa dans la chambre à préparations d'un appareil à faisceau de particules, le détecteur présentant un scintillateur (3) sur lequel un potentiel élevé peut être appliqué et un détecteur de lumière (1), **caractérisé en ce que** le scintillateur (3) présente un revêtement électriquement conducteur (4) configuré en grille ou en bandes ou un revêtement électriquement conducteur (4) perméable à la lumière et **en ce qu'**il est conçu à la fois pour la détection d'électrons et pour la détection de lumière.

2. Détecteur selon la revendication 1, dans lequel le détecteur présente un conducteur de lumière (2) situé entre le scintillateur (3) et le détecteur de lumière (1) .

3. Détecteur selon la revendication 2, dans lequel le conducteur de lumière (2) est constitué du matériau du scintillateur.

4. Détecteur selon l'une des revendications 1 à 3, dans lequel le détecteur présente une électrode (5) de collecteur en amont du scintillateur (3).

5. Détecteur selon la revendication 4, dans lequel le revêtement électriquement conducteur (4) du scintillateur (3) et l'électrode (5) de collecteur peuvent recevoir indépendamment l'un de l'autre des potentiels régulables.

6. Détecteur selon les revendications 4 ou 5, dans lequel l'électrode (5) de collecteur peut recevoir un potentiel variable mais positif par rapport au potentiel de l'échantillon.

7. Détecteur selon l'une des revendications 4 à 6, dans lequel des amplificateurs de courant sont raccordés à l'électrode (5) du collecteur et/ou au revêtement conducteur (4) du scintillateur (3).

8. Détecteur selon l'une des revendications 4 à 7, qui contient en outre des sources de tension (7, 8) qui créent en fonctionnement une différence de potentiel entre le revêtement conducteur (4) du scintillateur (3) et l'électrode (5) du collecteur de telle sorte qu'en fonctionnement, on obtienne une cascade de gaz entre l'électrode (5) de collecteur et le revêtement conducteur (4).

9. Détecteur selon l'une des revendications 1 à 8, dans lequel le détecteur présente une électrode (24) en aiguille ou une électrode constituée de minces fils du côté échantillon du scintillateur (3).

10. Détecteur selon l'une des revendications 1 à 9, dans lequel le détecteur présente une électrode (20, 22) qui entoure le scintillateur (3) en forme de chapeau, qui converge en pointe conique sur le côté non tourné vers le scintillateur (3) et qui présente sur son côté non tourné vers le scintillateur (3) une ouverture (21, 23).

11. Appareil à faisceau de particules, en particulier microscope électronique à balayage, qui présente une chambre (29) à préparations, l'appareil à faisceau de particules pouvant travailler avec une pression variable dans la chambre (29) à préparations et présentant un système électronique-optique de formation d'un faisceau d'électrons focalisés (PE) et un détecteur (2, 3, 4) selon l'une des revendications 1 à 10.

12. Appareil à faisceau de particules selon la revendication 11, dans lequel le détecteur présente un scintillateur (3) et la chambre à préparation présente un détecteur de pression (12), le potentiel appliqué sur le scintillateur (3) dépendant de la pression dans la chambre (29) à préparations.

13. Appareil à faisceau de particules selon la revendication 12, qui contient en outre une régulation (13) qui commute le potentiel appliqué sur le scintillateur en fonction de la pression déterminée par le détecteur de pression (12) dans la chambre (29) à préparations, la régulation (13) étant configurée de telle sorte qu'à des pressions inférieures à une pression de commutation comprise entre 10⁻³ hPa et 10⁻² hPa dans la chambre à préparations, un potentiel supérieur à 1 kV et positif par rapport au potentiel de l'échantillon (6) est appliqué sur le scintillateur (3) et qu'en cas de pression supérieure à la pression de commutation de la chambre à préparations, un potentiel inférieur à 1 kV et de préférence inférieur à 0,5 kV et positif par rapport au potentiel de l'échantillon (6) est appliqué sur le scintillateur (3).

14. Appareil à faisceau de particules selon les revendications 12 ou 13, dans lequel le détecteur présente une électrode (5) de collecteur et le signe du potentiel de l'électrode (5) de collecteur peut être inversé.

15. Appareil à faisceau de particules selon les revendications 13 ou 14, dans lequel un potentiel de 0 V ou de +/- 400 V par rapport au potentiel de l'échantillon (6) peut être appliqué sur l'électrode (5) de collecteur lorsque la pression qui règne dans la chambre à échantillon est supérieure à la pression de commutation .

16. Procédé de détection des produits d'interaction dans un appareil à faisceau de particules, dans lequel la lumière est créée par les produits d'interaction venant frapper un scintillateur lorsque la pression dans la chambre à préparations est inférieure à une pression de commutation et la lumière créée par interaction des produits d'interaction avec des molécules de gaz lorsque la pression dans la chambre à préparations est supérieure à la pression de commutation est détectée par le même détecteur de lumière (1) et est ensuite évaluée.

17. Procédé selon la revendication 16, dans lequel un détecteur selon l'une des revendications 1 à 10 est utilisé.
